(19) Europäisches Patentamt / European Patent Office / Office européen des brevets

(11) **EP 2 211 192 B1**

(12) **FASCICULE DE BREVET EUROPEEN**

(45) Date de publication et mention de la délivrance du brevet:
**25.07.2018 Bulletin 2018/30**

(51) Int Cl.:
***G01R 31/34*** *(2006.01)*

(21) Numéro de dépôt: **10305059.7**

(22) Date de dépôt: **19.01.2010**

(54) **Procédé de determination de l'échauffement d'une machine électrique tournante**

Verfahren zur Besitmmung der Erwärmung einer elektrischen Drehmaschine

Method for determining the heating up of an electrical rotating machine

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **21.01.2009 FR 0950367**

(43) Date de publication de la demande:
**28.07.2010 Bulletin 2010/30**

(73) Titulaire: **GE Energy Power Conversion Technology Limited**
**Rugby**
**Warwickshire CV21 1BU (GB)**

(72) Inventeurs:
- **Mirzaian, Abdollah**
  **90300 VALDOIE (FR)**
- **Manuelle, Pascal**
  **25200 GRAND-CHARMONT (FR)**
- **Dirand, Olivier**
  **90100 VEZELOIS (FR)**
- **Lateb, Ramdane**
  **54250 Champigneulles (FR)**
- **Mercier, Jean-Charles**
  **54710 LUDRES (FR)**

(74) Mandataire: **Serjeants LLP**
**Dock**
**75 Exploration Drive**
**Leicester, LE4 5NU (GB)**

(56) Documents cités:

- **PORTOS J ET AL: "Equivalent load test for large induction machines - the three step method", PETROLEUM AND CHEMICAL INDUSTRY TECHNICAL CONFERENCE, 2004. FIFTY-FIRS T ANNUAL CONFERENCE 2004 SAN FRANCISCO, CA, USA 13-15 SEPT. 2004, PISCATAWAY, NJ, USA,IEEE, US, 13 septembre 2004 (2004-09-13), pages 319-323, XP010738606, ISBN: 978-0-7803-8698-3**
- **NEVES C G C ET AL: "Comparative analyses of standards temperature rise test methods for induction machines", ELECTRICAL MACHINES, 2008. ICEM 2008. 18TH INTERNATIONAL CONFERENCE ON, IEEE, PISCATAWAY, NJ, USA, 6 septembre 2008 (2008-09-06), pages 1-5, XP031436100, ISBN: 978-1-4244-1735-3**
- **DYMOND J H: "Forward Stall Test-an alternate method of rotor and stator loading for temperature and vibration verification", PETROLEUM AND CHEMICAL INDUSTRY CONFERENCE, 1994. RECORD OF CONFERENCE PAPERS., INSTITUTE OF ELECTRICAL AND ELECTRONICS ENGINEERS INCORPORAT ED INDUSTRY APPLICATIONS SOCIETY 41ST ANNUAL VANCOUVER, BC, CANADA 12-14 SEPT. 1994, NEW YORK, NY, USA,IEEE, 12 septembre 1994 (1994-09-12), pages 153-157, XP010123981, ISBN: 978-0-7803-1987-5**
- **SHENKMAN A ET AL: "Methods of no-load thermal testing of induction motors", MEDITERRANEAN ELECTROTECHNICAL CONFERENCE, 1998. MELECON 98., 9TH TEL-AVIV, ISRAEL 18-20 MAY 1998, NEW YORK, NY, USA,IEEE, US, vol. 2, 18 mai 1998 (1998-05-18), pages 1165-1169, XP010290794, ISBN: 978-0-7803-3879-1**

**Description**

La présente invention concerne un procédé de détermination de l'échauffement dû à la totalité des pertes thermiques d'une machine électrique tournante moto-ventilée aux conditions de fonctionnement nominales définies par une fréquence d'alimentation nominale, une tension d'alimentation nominale, une intensité d'alimentation nominale et une vitesse de rotation nominale, la machine comprenant un rotor et un stator, ainsi qu'un moto-ventilateur équipé d'un dispositif d'entraînement propre, le moteur étant alimenté avec une fréquence d'alimentation, une tension d'alimentation et une intensité d'alimentation données.

Les moteurs électriques de forte puissance, de l'ordre de plusieurs Méga-watts ou plus nécessitent d'effectuer en usine après leur fabrication un essai d'échauffement dans les conditions nominales de fonctionnement pour déterminer leur échauffement.

De tels essais sont réalisés notamment conformément à la norme IEC 60034-29 Edition 1 de mars 2008. Cette norme prévoit dans sa partie 29 la description d'un procédé par charge équivalente et par superposition permettant des essais indirects pour déterminer l'échauffement des machines électriques tournantes.

Le procédé proposé met en oeuvre le mixage de deux fréquences d'alimentation obtenues à partir de deux machines tournantes différentes pour l'alimentation de la machine à tester. La machine à tester est ainsi soumise en permanence à une accélération et à un ralentissement, ce qui lui permet d'être chargée sans accouplement d'une charge externe.

Plus généralement, les normes de tests, ou les publications proposant des méthodes de tests proposent des procédés de détermination de l'échauffement qui nécessitent, soit l'utilisation de machines électriques tournantes additionnelles, soit l'utilisation des convertisseurs statiques bidirectionnels en puissance.

L'usage de machines tournantes additionnelles pour le test crée un coût d'installation et de maintenance dans l'usine élevé, alors que ces machines additionnelles ne sont utilisées que rarement, puisqu'elles sont utilisées seulement lors des phases de test.

Les machines additionnelles doivent être adaptées à la machine tournante à tester. Or, les puissances des machines tournantes ont tendance à augmenter pour satisfaire les besoins du marché. Ainsi, aujourd'hui des moteurs asynchrones de forte puissance atteignant aisément 25 MW et alimentés par des convertisseurs statiques de fréquence sont construits et installés, notamment pour les applications de propulsion marine. Les usines de construction des moteurs ne sont en général pas dimensionnées pour permettre le test direct à la puissance nominale de ces machines et ne disposent pas de machines électriques tournantes additionnelles permettant leur test.

De même, l'utilisation de convertisseurs statiques bidirectionnels en puissance crée un échange de puissance électrique entre la machine et le réseau de l'usine de valeur importante de l'ordre de 0,5 à 1 fois la puissance nominale de la machine. Cet échange est généralement incompatible avec les caractéristiques du réseau électrique de l'usine. De plus, il est souvent nécessaire de recourir à un convertisseur bidirectionnel spécifique, car le convertisseur prévu pour l'alimentation en fonctionnement normal du moteur à tester peut être monodirectionnel.

Ainsi, les procédés proposés pour l'essai d'échauffement normal engendrent des contraintes particulières sur le réseau électrique de l'usine et dans la plupart des cas nécessitent de recourir à des machines électriques additionnelles ou des convertisseurs additionnels qui engendrent un surcoût propre au test d'essai d'échauffement très important.

L'invention a pour but de proposer un procédé d'essai d'échauffement facilement applicable en usine et ne nécessitant pas d'équipement particulier important.

A cet effet, l'invention a pour objet un procédé de détermination de l'échauffement du type précité, caractérisé en ce qu'il comprend trois étapes :

a) une étape de mesure d'un premier échauffement de la machine alors que :

- le rotor est immobilisé par rapport au stator,
- la fréquence d'alimentation est une première fréquence réduite,
- la tension d'alimentation est une première tension réduite,
- l'intensité d'alimentation est l'intensité nominale,
- la ventilation est en marche,

b) une étape de mesure d'un deuxième échauffement de la machine alors que :

- le rotor tourne à une vitesse de rotation réduite sans charge,
- la fréquence d'alimentation est une deuxième fréquence réduite,
- la tension d'alimentation est une deuxième tension réduite,
- l'intensité d'alimentation est une deuxième intensité réduite,

la ventilation est en marche,

c) une étape de mesure d'un troisième échauffement de la machine alors que :

- le rotor tourne à la vitesse de rotation nominale sans charge,
- la fréquence d'alimentation est la fréquence nominale,
- la tension d'alimentation est la tension nominale,
- l'intensité d'alimentation est égale à l'intensité du courant magnétisant nominale de la machine
- la ventilation est en marche,

d) une étape de calcul à partir des premier, deuxième et troisième échauffements l'échauffement aux conditions de fonctionnement nominal.

Suivant des modes particuliers de mise en oeuvre, le procédé comporte l'une ou plusieurs des caractéristiques suivantes :

- la première tension réduite est sensiblement égale à $(2\pi F_1 \times L\sigma) \times I_1$
  où
  $F_1$ est la première fréquence réduite dont la valeur se situe entre la fréquence de glissement nominal et environ 3 Hz,
  $\overline{La}$ est l'inductance de fuite totale du rotor et du stator, et
  $I_1$ est l'intensité nominale ;
- la deuxième tension réduite est égale à la première tension réduite ;
- la deuxième fréquence réduite est égale à la première fréquence réduite ;
- la deuxième intensité réduite est sensiblement égale à $U_2/(2\pi F_2 \times L_1)$
  où
  $U_2$ est la deuxième tension réduite,
  $F_2$ est la deuxième fréquence réduite, et
  $L_1$ est l'inductance totale du stator ;
- Procédé selon l'une quelconque des revendications précédentes, caractérisé en ce que le courant magnétisant nominal est sensiblement égal à $U_N/(2\pi F_N \times L_1)$
  où
  $U_N$ est la tension nominale,
  $F_N$ est la fréquence nominale, et
  $L_1$ est l'inductance totale du stator ;

- lors des trois étapes de mesure, la ventilation est assurée dans des conditions de refroidissement nominales identiques à celles du fonctionnement de la machine à une charge nominale ; et
- la circulation d'un courant rotorique dans le rotor est assurée par le couplage magnétique entre le stator et le rotor de la machine.

L'invention a également pour objet une installation de détermination de l'échauffement dû à la totalité des pertes thermiques d'une machine électrique tournante moto-ventilée aux conditions de fonctionnement nominales définies par une fréquence d'alimentation nominale, une tension d'alimentation nominale, une intensité d'alimentation nominale et une vitesse de rotation nominale, la machine comprenant un rotor et un stator, ainsi qu'un moto-ventilateur équipé d'un dispositif d'entraînement propre, caractérisée en ce que l'installation comporte des moyens pour alimenter le moteur avec une fréquence d'alimentation, une tension d'alimentation, une intensité d'alimentation données, des moyens de blocage en rotation du rotor du moteur par rapport au stator, et en ce qu'elle comprend :

a) des moyens de mesure d'un premier échauffement de la machine alors que :

- le rotor est immobilisé par rapport au stator,
- la fréquence d'alimentation est une première fréquence réduite,
- la tension d'alimentation est une première tension réduite,
- l'intensité d'alimentation est l'intensité nominale,
- la ventilation est en marche,

b) des moyens de mesure d'un deuxième échauffement de la machine alors que :

- le rotor tourne à une vitesse de rotation réduite sans charge,

- la fréquence d'alimentation est une deuxième fréquence réduite,
- la tension d'alimentation est une deuxième tension réduite,
- l'intensité d'alimentation est une deuxième intensité réduite,

la ventilation est en marche,
c) des moyens de mesure d'un troisième échauffement de la machine alors que :

- le rotor tourne à la vitesse de rotation nominale sans charge,
- la fréquence d'alimentation est la fréquence nominale,
- la tension d'alimentation est la tension nominale,
- l'intensité d'alimentation est égale à l'intensité du courant magnétisant nominale de la machine
- la ventilation est en marche,

d) des moyens de calcul à partir des premier, deuxième et troisième échauffements l'échauffement aux conditions de fonctionnement nominal.

L'invention sera mieux comprise à la lecture de la description qui va suivre, donnée uniquement à titre d'exemple et faite en se référant aux dessins sur lesquels :

- la figure 1 est une vue schématique de l'installation de tests d'échauffement pour la mise en oeuvre du procédé selon l'invention ;
- la figure 2 est un organigramme du procédé mis en oeuvre, et
- La figure 3 est le schéma dit "Back to Back" utilisé pour la validation de la nouvelle méthode proposée.

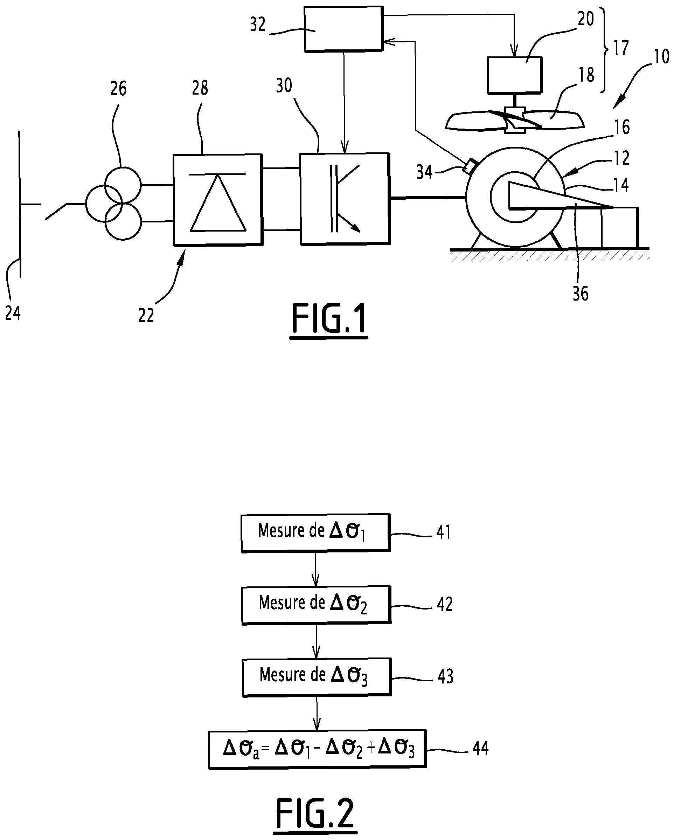

Le banc de test 10 illustré sur la figure 1 est destiné à déterminer l'échauffement total dû aux pertes thermiques d'un moteur asynchrone 12 moto-ventilé aux conditions de fonctionnement nominales par mise en oeuvre d'un procédé selon l'invention. Le procédé est mis en oeuvre dans l'usine de fabrication du moteur après achèvement de celui-ci.

Le moteur 12 comporte un stator 14 équipé d'un bobinage statorique permettant l'alimentation du moteur, et un rotor 16 mobile autour de l'axe du stator.

Pour sa ventilation, le moteur comporte un moto-ventilateur 17 formé d'une hélice 18 mue par un dispositif d'entraînement 20 indépendant de la rotation propre du rotor 16. L'hélice et son dispositif d'entraînement sont représentés schématiquement sur la figure 1. En pratique, le moto-ventilateur est intégré à la structure du stator.

Le banc de test comporte un convertisseur 22 formant une chaîne d'alimentation du moteur relié entre un réseau 24 d'alimentation propre à l'usine et le moteur 12. Ce convertisseur 22 comporte successivement, depuis le réseau d'alimentation, un transformateur 26, un redresseur 28 et un onduleur 30 permettant la mise en forme du courant d'alimentation. A cet effet, l'onduleur comporte un ensemble d'interrupteurs statiques commandés. De préférence le convertisseur 22 est propre au moteur 12, c'est-à-dire qu'après le test, le convertisseur est utilisé pour l'alimentation du moteur en production.

Le banc de test comporte une unité de pilotage et de mesure 32 propre à assurer la commande de l'onduleur 30, ainsi que l'alimentation du moto-ventilateur 17.

En outre, le banc de test comporte des capteurs de température 34 placés aux positions adaptées du moteur, ces sondes de température étant reliées à l'unité de pilotage et de mesure 32.

Enfin, le banc de test comporte des moyens amovibles 36 d'immobilisation en rotation du rotor 16 par rapport au stator 14. Ces moyens sont formés par exemple d'un bras de blocage de l'axe du rotor par rapport au stator, ce bras étant dimensionné pour supporter au moins le couple nominal du moteur dans les deux sens de rotation.

Comme illustré schématiquement sur la figure 2, le procédé de détermination de l'échauffement comprend trois mesures de l'échauffement lors de trois essais successifs dans des conditions d'utilisation du moteur différentes et une phase finale de calcul de l'échauffement aux conditions nominales, à partir des valeurs d'échauffement mesurées lors des trois essais précédents.

Pour ces trois essais, une commande particulière du moteur est imposée par l'unité de pilotage et de mesure 32. Les conditions de fonctionnement du moteur sont définies par les caractéristiques du courant électrique alimentant le bobinage statorique du moteur et donc la fréquence d'alimentation F du moteur, la tension d'alimentation U du moteur et l'intensité I d'alimentation du moteur.

Par construction, le moteur est dimensionné pour fonctionner à une fréquence d'alimentation nominale $F_N$, une tension d'alimentation nominale $U_N$ et une intensité d'alimentation nominale $I_N$ avec une vitesse de rotation nominale $N_N$ pour un couple nominal $C_N$.

Lors de chaque essai, un échauffement dû à des pertes dont la nature est connue et identifiée est déterminé.

Lors de ces essais, l'échauffement du moteur est lié essentiellement aux quatre causes suivantes. La circulation du courant dans les bobinages, a priori en cuivre crée des pertes par effet Joule. Les pertes magnétiques dans le circuit magnétique, couramment en fer, s'ajoutent. Les pertes harmoniques s'ajoutent également, ainsi que les pertes mécaniques dues au frottement entre les différents éléments du moteur.

Chaque échauffement mesuré est utilisé ensuite pour le calcul de l'échauffement dû à la totalité des pertes dans la machine aux conditions de fonctionnement nominales.

Lors des trois essais, le moto-ventilateur 17 est en marche de sorte que les conditions de refroidissement du moteur soient identiques à celles du fonctionnement en charge nominale.

De plus, la circulation du courant rotorique est assurée lors des tests par le couplage magnétique du stator et du rotor de la machine.

Le premier essai, correspondant à l'étape 41 de la figure 2 est réalisé avec le rotor 16 du moteur immobilisé en rotation par rapport au stator 14 par blocage à l'aide du bras adapté 36.

Le stator est alimenté avec une intensité $I_1$ égale à l'intensité nominale $I_N$.

Dans cette configuration la fréquence du courant rotorique est égale à celle du stator, car la valeur du glissement est égale à 1. Afin de ne pas engendrer de pertes excessives dans le rotor, du fait de l'augmentation de la résistance rotorique due à l'effet Kelvin, la fréquence du courant d'alimentation $F_1$ est réduite, c'est-à-dire qu'elle est inférieure à la fréquence nominale d'alimentation $F_N$. Avantageusement, la fréquence réduite d'alimentation $F_1$ est voisine de la fréquence de glissement nominale (généralement inférieure à 1 Hz) mais peut aller jusqu'à 3 Hz environ.

La tension d'alimentation $U_1$ est réduite et inférieure à la tension d'alimentation nominale $U_N$. La tension statorique $U_1$ est sensiblement égale à :

$$U_1 = (2\pi F_1 \times L\sigma) \times I_1$$

où

$F_1$ est la première fréquence réduite,
La est l'inductance de fuite totale du rotor et du stator, et
$I_1$ est l'intensité du courant égale à l'intensité nominale $I_N$.

Lors de cet essai, les pertes par effet Joule sont prédominantes, l'essai étant fait avec une intensité nominale. Les pertes dans le circuit magnétique et les pertes harmoniques sont faibles alors que les pertes mécaniques sont nulles.

Pendant cet essai, le stator est alimenté par une fréquence réduite $F_1$ inférieure à la fréquence nominale $F_N$. Par contre, le rotor étant bloqué, les courants rotoriques ont la même fréquence que celle du stator. Cette fréquence est supérieure à la fréquence des courants rotoriques dans des conditions nominales. Comparées aux conditions nominales de fonctionnement, l'essai est légèrement plus favorable pour le stator et moins favorable pour le rotor. Dans l'ensemble, l'influence de la réduction de la fréquence par rapport aux conditions nominales reste négligeable.

L'essai d'échauffement suivant réalisé à l'étape 42 est fait alors que le rotor est en rotation à basse vitesse par rapport au stator sans charge après que le bras 36 a été retiré. La vitesse $N_2$ est inférieure à la vitesse nominale $N_N$. La fréquence d'alimentation $F_2$ est réduite et est égale à la fréquence réduite $F_1$ du premier essai.

De même, la tension $U_2$ est réduite et est égale à la tension d'alimentation $U_1$ du premier essai.

L'intensité $I_2$ du courant statorique est également réduite. Elle est sensiblement égale à :

$$I_2 = U_2/(2\pi F_2 \times L_1)$$

où

$U_2$ est la deuxième tension réduite,
$F_2$ est la deuxième fréquence réduite, et
$L_1$ est l'inductance totale du stator.

Dans ce cas, les pertes par effet Joule sont faibles et les pertes dans le circuit magnétique et les pertes harmoniques sont quasiment identiques à celles du premier essai. Enfin, les pertes mécaniques sont très faibles.

Lors du troisième essai d'échauffement réalisé à l'étape 43, le rotor 16 tourne par rapport au stator 14 à la vitesse nominale $N_N$ sans charge. Le stator est alimenté à la fréquence nominale $F_N$ sous la tension nominale $U_N$. Le courant statorique d'alimentation $I_3$ est égal au courant magnétisant nominal $I_o$ de la machine, lequel est, sensiblement égal à :

$$I_o = U_N/(2\pi F_N \times L_1)$$

où

$U_N$ est la tension nominale,

$F_N$ est la fréquence nominale, et

$L_1$ est l'inductance totale du stator.

Dans cet essai d'échauffement, les pertes par effet Joule sont faibles puisque dues seulement au courant magnétisant $I_o$. Les pertes magnétiques, les pertes harmoniques et les pertes mécaniques sont celles rencontrées dans les conditions nominales de fonctionnement du moteur.

A l'étape 44, on calcule l'échauffement total $\Delta\theta_a$ de la machine pour un fonctionnement dans les conditions nominales.

Cet échauffement est donné par $\Delta\theta_a = \Delta\theta_1 - \Delta\theta_2 + \Delta\theta_3$.

L'échauffement calculé correspond aux pertes par effet joule, aux pertes dans le circuit magnétique, aux pertes harmoniques et aux pertes mécaniques aux conditions nominales.

Le procédé décrit procure l'avantage de ne nécessiter aucune machine additionnelle. Seul le moteur à tester et le convertisseur propre au moteur fabriqué pour l'application suffisent pour déterminer l'échauffement du moteur dans les conditions de fonctionnement nominales.

L'échange de puissance électrique avec le réseau est constante et faible. Lors des essais, seule la somme des pertes du moteur 12 et celles du convertisseur 22 est à fournir par le réseau, ces pertes n'excèdent pas 5% de la puissance absorbée en pleine charge et dans les conditions nominales. La sollicitation du réseau d'usine est donc parfaitement acceptable. La puissance électrique circule en permanence du réseau vers le moteur de sorte qu'aucune énergie n'est envoyée vers le réseau de l'usine, préservant ainsi celui-ci.

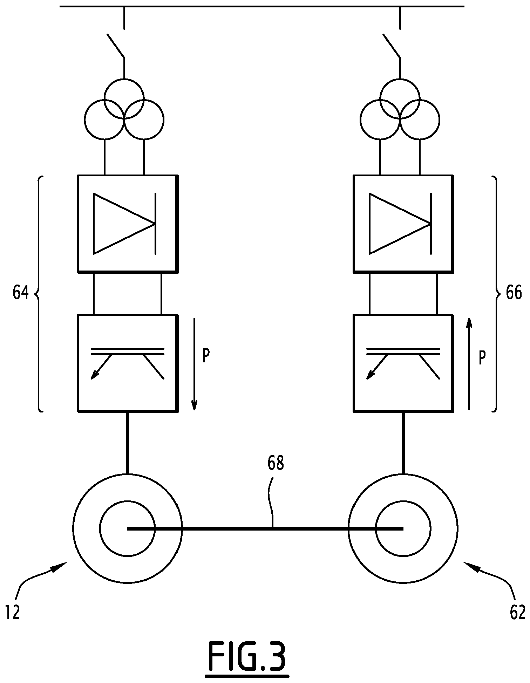

La présente méthode a été comparée à la méthode dite de « Back to Back » explicitée dans la norme IEC 60034-2 et en regard de la figure 3. Pour cet essai, deux moteurs identiques de propulsion marine 12, 62 et deux convertisseurs associés identiques ont été utilisés. Chaque moteur a une puissance nominale de 24 MW, une vitesse de rotation nominale $N_N$ de 130 tr/mn sous une tension d'alimentation nominale $U_N$ de 6600 volts avec une intensité nominale $I_N$ d'alimentation de 2496 ampères, la fréquence nominale $F_N$ d'alimentation étant de 13,13 Hz, et le moteur ayant 12 pôles.

Pour l'essai d'échauffement mettant en oeuvre la méthode « Back to Back », les deux moteurs identiques ont été couplés mécaniquement par des moyens de liaison 68. Le moteur à tester fonctionne en moteur alors que l'autre machine tournante fonctionne en générateur. Les deux machines tournantes tournent dans les mêmes conditions nominales, c'est-à-dire mêmes tensions nominales, même courant nominal et même vitesse nominale. Ainsi, le réseau d'usine ne fournit que les pertes des deux machines tournantes et des convertisseurs. Dans ces conditions, les pertes nominales sont générées dans les deux machines tournantes et l'échauffement $\Delta\theta_b$ a été mesuré égal à 77° K.

Les conditions pour les mesures des échauffements lors des trois essais successifs par mise en oeuvre du procédé selon l'invention sur le moteur à tester sont indiquées ci-dessous :

Conditions des essais :

- L'essai N1 :
  $U_1$=456 V eff, $F_1$ = 3 Hz, $I_1$ = 2496 A eff,

- L'essai N2 :
  $U_2$=456 V eff, $F_2$ = 3Hz, $I_2$ = 101 A eff
- L'essai N3 :

  $U_3$=6600 V eff, $F_3$ = 13,13 Hz, $I_3$ = 505 A eff.

Les valeurs de l'échauffement mesuré lors des trois essais sont relatées dans le tableau qui suit, la valeur d'échauffement calculée par la méthode selon l'invention $\Delta\theta_a$ étant égale à 76,4°K.

| Méthode | $\Delta\theta1$°K | $\Delta\theta2$°K | $\Delta\theta3$°K | $\Delta\theta a$°K | $\Delta\theta b$°K |
|---|---|---|---|---|---|
| Nouvelle méthode proposée | 70.23 | 5.16 | 11.32 | 76.4 | x |
| Test Back to Back | x | x | x | x | 77 |

Ainsi, les deux méthodes donnent un échauffement ne différant que de l'ordre de 1%.

**Revendications**

1. Procédé de détermination de l'échauffement dû à la totalité des pertes thermiques d'une machine électrique tournante moto-ventilée aux conditions de fonctionnement nominales définies par une fréquence d'alimentation nominale ($F_N$), une tension d'alimentation nominale ($U_N$), une intensité d'alimentation nominale ($I_N$) et une vitesse de rotation nominale ($N_N$), la machine comprenant un rotor et un stator, ainsi qu'un moto-ventilateur équipé d'un dispositif d'entraînement propre, le moteur étant alimenté avec une fréquence d'alimentation, une tension d'alimentation et une intensité d'alimentation données, **caractérisé en ce qu'**il comprend trois étapes :

   a) une étape (41) de mesure d'un premier échauffement $\Delta\theta_1$ de la machine alors que :

   - le rotor est immobilisé par rapport au stator,
   - la fréquence d'alimentation est une première fréquence réduite ($F_1$),
   - la tension d'alimentation est une première tension réduite ($U_1$),
   - l'intensité d'alimentation est l'intensité nominale ($I_1 = I_N$),
   - la ventilation est en marche,

   b) une étape (42) de mesure d'un deuxième échauffement $\Delta\theta_2$ de la machine alors que :

   - le rotor tourne à une vitesse de rotation réduite sans charge ,
   - la fréquence d'alimentation est une deuxième fréquence réduite ($F_2$),
   - la tension d'alimentation est une deuxième tension réduite ($U_2$),
   - l'intensité d'alimentation est une deuxième intensité réduite ($I_2$),

   la ventilation est en marche,
   c) une étape (43) de mesure d'un troisième échauffement $\Delta\theta_3$ de la machine alors que :

   - le rotor tourne à la vitesse de rotation nominale sans charge ,
   - la fréquence d'alimentation est la fréquence nominale ($F_N$),
   - la tension d'alimentation est la tension nominale ($U_N$),
   - l'intensité d'alimentation est égale à l'intensité du courant magnétisant nominale ($I_o$) de la machine
   - la ventilation est en marche,

   d) une étape (44) de calcul, à partir des premier, deuxième et troisième échauffements, de l'échauffement aux conditions de fonctionnement nominal par :

$$\Delta\theta_a = \Delta\theta_1 - \Delta\theta_2 + \Delta\theta_3.$$

2. Procédé selon la revendication 1, **caractérisé en ce que** la première tension réduite ($U_1$) est sensiblement égale à :

$$U_1 = (2\pi F_1 \times L\sigma) \times I_1$$

   où
   $F_1$ est la première fréquence réduite dont la valeur se situe entre la fréquence de glissement nominal et environ 3 Hz,
   $L\sigma$ est l'inductance de fuite totale du rotor et du stator, et
   $I_1$ est l'intensité nominale.

3. Procédé selon l'une quelconque des revendications précédentes, **caractérisé en ce que** la deuxième tension réduite ($U_2$) est égale à la première tension réduite ($U_1$).

4. Procédé selon l'une quelconque des revendications précédentes, **caractérisé en ce que** la deuxième fréquence réduite ($F_2$) est égale à la première fréquence réduite ($F_1$).

5. Procédé selon l'une quelconque des revendications précédentes, **caractérisé en ce que** la deuxième intensité réduite $I_2$ est sensiblement égale à :

$$I_2 = U_2/(2\pi F_2 \times L_1)$$

Où
$U_2$ est la deuxième tension réduite,
$F_2$ est la deuxième fréquence réduite, et
$L_1$ est l'inductance totale du stator.

6. Procédé selon l'une quelconque des revendications précédentes, **caractérisé en ce que** le courant magnétisant nominal $I_o$ est sensiblement égal à :

$$I_o = U_N/(2\pi F_N \times L_1)$$

où
$U_N$ est la tension nominale,
$F_N$ est la fréquence nominale, et $L_1$ est l'inductance totale du stator.

7. Procédé selon l'une quelconque des revendications précédentes, **caractérisé en ce que**, lors des trois étapes de mesure, la ventilation est assurée dans des conditions de refroidissement nominales identiques à celles du fonctionnement de la machine à une charge nominale.

8. Procédé selon l'une quelconque des revendications précédentes, **caractérisé en ce que** la circulation d'un courant rotorique dans le rotor est assurée par le couplage magnétique entre le stator et le rotor de la machine.

9. Installation de détermination de l'échauffement dû à la totalité des pertes thermiques d'une machine électrique tournante moto-ventilée aux conditions de fonctionnement nominales définies par une fréquence d'alimentation nominale ($F_N$), une tension d'alimentation nominale ($U_N$), une intensité d'alimentation nominale ($I_N$) et une vitesse de rotation nominale ($N_N$), la machine comprenant un rotor et un stator, ainsi qu'un moto-ventilateur équipé d'un dispositif d'entraînement propre, **caractérisée en ce que** l'installation comporte des moyens pour alimenter le moteur avec une fréquence d'alimentation, une tension d'alimentation et une intensité d'alimentation données et des moyens (36) de blocage en rotation du rotor du moteur par rapport au stator, et **en ce qu'**elle comprend :

    a) des moyens (32, 34) de mesure d'un premier échauffement $\Delta\theta_1$ de la machine alors que :

        - le rotor est immobilisé par rapport au stator,
        - la fréquence d'alimentation est une première fréquence réduite ($F_1$),
        - la tension d'alimentation est une première tension réduite ($U_1$),
        - l'intensité d'alimentation est l'intensité nominale ($I_1 = I_N$),
        - la ventilation est en marche,

    b) des moyens (32, 34) de mesure d'un deuxième échauffement $\Delta\theta_2$ de la machine alors que :

        - le rotor tourne à une vitesse de rotation réduite sans charge ,
        - la fréquence d'alimentation est une deuxième fréquence réduite ($F_2$),
        - la tension d'alimentation est une deuxième tension réduite ($U_2$),
        - l'intensité d'alimentation est une deuxième intensité réduite ($I_2$),

    la ventilation est en marche,
    c) des moyens (32, 34) de mesure d'un troisième échauffement $\Delta\theta_3$ de la machine alors que :

        - le rotor tourne à la vitesse de rotation nominale sans charge ,
        - la fréquence d'alimentation est la fréquence nominale ($F_N$),
        - la tension d'alimentation est la tension nominale ($U_N$),
        - l'intensité d'alimentation est égale à l'intensité du courant magnétisant nominale ($I_o$) de la machine
        - la ventilation est en marche,

    d) des moyens (32) de calcul, à partir des premier, deuxième et troisième échauffements, de l'échauffement aux conditions de fonctionnement nominal par :

$$\Delta\theta_a = \Delta\theta_1 - \Delta\theta_2 + \Delta\theta_3.$$

## Patentansprüche

1. Verfahren zur Bestimmung der auf die Gesamtheit der Wärmeverluste zurückzuführenden Erwärmung einer motorbelüfteten elektrischen Drehmaschine unter Nennbetriebsbedingungen, die durch eine Nennversorgungsfrequenz ($F_N$), eine Nennversorgungsspannung ($U_N$), eine Nennversorgungsstromstärke ($I_N$) und eine Nenndrehzahl ($N_N$) definiert sind, wobei die Maschine einen Rotor und einen Stator sowie einen Motorlüfter aufweist, der mit einer eigenen Antriebsvorrichtung ausgestattet ist, wobei der Motor mit einer bestimmten Versorgungsfrequenz, einer bestimmten Versorgungsspannung und einer bestimmten Versorgungsstromstärke gespeist wird, **dadurch gekennzeichnet, dass** es drei Schritte aufweist:

   a) einen Schritt (41) des Messens einer ersten Erwärmung $\Delta\theta_1$ der Maschine, während:

   - der Rotor in Bezug auf den Stator fixiert ist,
   - die Versorgungsfrequenz eine erste reduzierte Frequenz ($F_1$) ist,
   - die Versorgungsspannung eine erste reduzierte Spannung ($U_1$) ist,
   - die Versorgungsstromstärke die Nennstromstärke ist ($I_1=I_N$),
   - die Lüftung läuft,

   b) einen Schritt (42) des Messens einer zweiten Erwärmung $\Delta\theta_2$ der Maschine, während:

   - der Rotor mit einer reduzierten Drehzahl ohne Last dreht,
   - die Versorgungsfrequenz eine zweite reduzierte Frequenz ($F_2$) ist,
   - die Versorgungsspannung eine zweite reduzierte Spannung ($U_2$) ist,
   - die Versorgungsstromstärke eine zweite reduzierte Stromstärke ($I_2$) ist,
   - die Lüftung läuft,

   c) einen Schritt (43) des Messens einer dritten Erwärmung $\Delta\theta_3$ der Maschine, während:

   - der Rotor mit der Nenndrehzahl ohne Last dreht,
   - die Versorgungsfrequenz die Nennfrequenz ($F_N$) ist,
   - die Versorgungsspannung die Nennspannung ($U_N$) ist,
   - die Versorgungsstromstärke gleich der Stromstärke ($I_o$) des Nennmagnetisierungsstroms der Maschine ist,
   - die Lüftung läuft,

   d) einen Schritt (44) des Berechnens der Erwärmung unter Nennbetriebsbedingungen anhand der ersten, zweiten und dritten Erwärmung gemäß:

$$\Delta\theta_a = \Delta\theta_1 - \Delta\theta_2 + \Delta\theta_3.$$

2. Verfahren nach Anspruch 1, **dadurch gekennzeichnet, dass** die erste reduzierte Spannung ($U_1$) im Wesentlichen gleich ist:

$$U_1 = (2\pi F_1 \times L\sigma) \times I_1$$

   worin
   $F_1$ die erste reduzierte Frequenz ist, deren Wert zwischen der Nennschlupffrequenz und ungefähr 3 Hz liegt,
   $L\sigma$ die gesamte Leckinduktivität des Rotors und des Stators ist, und
   $I_1$ die Nennstromstärke ist.

3. Verfahren nach einem beliebigen der vorhergehenden Ansprüche, **dadurch gekennzeichnet, dass** die zweite

reduzierte Spannung ($U_2$) gleich der ersten reduzierten Spannung ($U_1$) ist.

4. Verfahren nach einem beliebigen der vorhergehenden Ansprüche, **dadurch gekennzeichnet, dass** die zweite reduzierte Frequenz ($F_2$) gleich der ersten reduzierten Frequenz ($F_1$) ist.

5. Verfahren nach einem beliebigen der vorhergehenden Ansprüche, **dadurch gekennzeichnet, dass** die zweite reduzierte Stromstärke $I_2$ im Wesentlichen gleich ist:

$$I_2 = U_2/(2\pi F_2 \times L_1)$$

worin
$U_2$ die zweite reduzierte Spannung ist,
$F_2$ die zweite reduzierte Frequenz ist und
$L_1$ die Gesamtinduktivität des Stators ist.

6. Verfahren nach einem beliebigen der vorhergehenden Ansprüche, **dadurch gekennzeichnet, dass** der Nennmagnetisierungsstrom $I_0$ im Wesentlichen gleich ist:

$$I_0 = U_N/(2\pi F_N \times L_1),$$

worin
$U_N$ die Nennspannung ist,
$F_N$ die Nennfrequenz ist und
$L_1$ die Gesamtinduktivität des Stators ist.

7. Verfahren nach einem beliebigen der vorhergehenden Ansprüche, **dadurch gekennzeichnet, dass** während der drei Messschritte die Belüftung unter den gleichen Nennkühlbedingungen wie diejenigen des Betriebs der Maschine unter Nennlast sichergestellt ist.

8. Verfahren nach einem beliebigen der vorhergehenden Ansprüche, **dadurch gekennzeichnet, dass** die Zirkulation des Rotorstroms in dem Rotor durch die magnetische Kopplung zwischen dem Stator und dem Rotor der Maschine sichergestellt wird.

9. Einrichtung zur Bestimmung der auf die Gesamtheit der Wärmeverluste zurückzuführenden Erwärmung einer motorbelüfteten elektrischen Drehmaschine unter Nennbetriebsbedingungen, die durch eine Nennversorgungsfrequenz ($F_N$), eine Nennversorgungsspannung ($U_N$), eine Nennversorgungsstromstärke ($I_N$) und eine Nenndrehzahl ($N_N$) definiert sind, wobei die Maschine einen Rotor und einen Stator sowie einen Motorlüfter aufweist, der mit einer eigenen Antriebsvorrichtung ausgestattet ist, **dadurch gekennzeichnet, dass** die Einrichtung Mittel zur Speisung des Motors mit einer bestimmten Versorgungsfrequenz, einer bestimmten Versorgungsspannung und einer bestimmten Versorgungsstromstärke und Mittel (36) zur Drehsicherung des Rotors des Motors in Bezug auf den Stator aufweist und dass sie aufweist:

a) Mittel (32, 34) zur Messung einer ersten Erwärmung $\Delta\theta_1$ der Maschine, während:

- der Rotor in Bezug auf den Stator fixiert ist,
- die Versorgungsfrequenz eine erste reduzierte Frequenz ($F_1$) ist,
- die Versorgungsspannung eine erste reduzierte Spannung ($U_1$) ist,
- die Versorgungsstromstärke die Nennstromstärke ist ($I_1=I_N$),
- die Lüftung läuft,

b) Mittel (32, 34) zur Messung einer zweiten Erwärmung $\Delta\theta_2$ der Maschine, während:

- der Rotor mit einer reduzierten Drehzahl ohne Last dreht,
- die Versorgungsfrequenz eine zweite reduzierte Frequenz ($F_2$) ist,
- die Versorgungsspannung eine zweite reduzierte Spannung ($U_2$) ist,
- die Versorgungsstromstärke eine zweite reduzierte Stromstärke ($I_2$) ist,

- die Lüftung läuft,

c) Mittel (32, 34) zur Messung einer dritten Erwärmung $\Delta\theta_3$ der Maschine, während:

- der Rotor mit der Nenndrehzahl ohne Last dreht,
- die Versorgungsfrequenz die Nennfrequenz ($F_N$) ist,
- die Versorgungsspannung die Nennspannung ($U_N$) ist,
- die Versorgungsstromstärke gleich der Stromstärke ($I_o$) des Nennmagnetisierungsstroms der Maschine ist,
- die Lüftung läuft,

d) Mittel (32) zur Berechnung der Erwärmung unter Nennbetriebsbedingungen anhand der ersten, zweiten und dritten Erwärmung gemäß:

$$\Delta\theta_a = \Delta\theta_1 - \Delta\theta_2 + \Delta\theta_3.$$

**Claims**

1. Method for determining the heating up, due to the totality of thermal losses, of an electrical rotating machine with motorised ventilation, under nominal operating conditions defined by a nominal supply frequency ($F_N$), a nominal supply voltage ($U_N$), a nominal supply intensity ($I_N$) and a nominal rotation speed ($N_N$), the machine comprising a rotor and a stator and a motorised fan equipped with a specific drive device, the motor being supplied with a given supply frequency, supply voltage and supply intensity, **characterised in that** it comprises three steps:

   a) a step (41) of measuring a first heating value $\Delta\theta_1$ of the machine when:

   - the rotor is immobilized relative to the stator,
   - the supply frequency is a first reduced frequency ($F_1$),
   - the supply voltage is a first reduced voltage ($U_1$),
   - the supply intensity is the nominal intensity ($I_1 = I_N$),
   - the ventilation is in operation,

   b) a step (42) of measuring a second heating value $\Delta\theta_2$ of the machine when:

   - the rotor is turning at a reduced rotation speed without load,
   - the supply frequency is a second reduced frequency ($F_2$),
   - the supply voltage is a second reduced voltage ($U_2$),
   - the supply intensity is a second reduced intensity ($I_2$),
   - the ventilation is in operation,

   c) a step (43) of measuring a third heating value $\Delta\theta_3$ of the machine when:

   - the rotor is turning at the nominal rotation speed without load,
   - the supply frequency is the nominal frequency ($F_N$),
   - the supply voltage is the nominal voltage ($U_N$),
   - the supply intensity is equal to the intensity of the nominal magnetising current ($I_o$) of the machine,
   - the ventilation is in operation,

   d) a step (44) of calculating, from the first, second and third heating values, the heating under nominal operating conditions by:

$$\Delta\theta_a = \Delta\theta_1 - \Delta\theta_2 + \Delta\theta_3.$$

2. Method according to claim 1, **characterised in that** the first reduced voltage ($U_1$) is substantially equal to:

$$U_1 = (2\pi F_1 \times L\sigma) \times I_1$$

where:

$F_1$ is the first reduced frequency, the value of which lies between the nominal slip frequency and approximately 3 Hz,
$L\sigma$ is the total leakage inductance of the rotor and stator, and
$I_1$ is the nominal intensity.

3. Method as claimed in any of the preceding claims, **characterised in that** the second reduced voltage ($U_2$) is equal to the first reduced voltage ($U_1$).

4. Method as claimed in any of the preceding claims, **characterised in that** the second reduced frequency ($F_2$) is equal to the first reduced frequency ($F_1$).

5. Method as claimed in any of the preceding claims, **characterised in that** the second reduced intensity $I_2$ is substantially equal to:

$$I_2 = U_2/(2\pi F_2 \times L_1)$$

where:

$U_2$ is the second reduced voltage,
$F_2$ is the second reduced frequency, and
$L_1$ is the total inductance of the stator.

6. Method as claimed in any of the preceding claims, **characterised in that** the nominal magnetising current $I_o$ is substantially equal to:

$$I_o = U_N/(2\pi F_N \times L_1)$$

where:

$U_N$ is the nominal voltage,
$F_N$ is the nominal frequency, and
$L_1$ is the total inductance of the stator.

7. Method as claimed in any of the preceding claims, **characterised in that** during the three measuring steps, the ventilation is ensured under nominal cooling conditions identical to those of operation of the machine under nominal load.

8. Method as claimed in any of the preceding claims, **characterised in that** circulation of a rotor current in the rotor is ensured by the magnetic coupling between the stator and the rotor of the machine.

9. Installation for determining the heating up, due to the totality of thermal losses, of an electrical rotating machine with motorised ventilation, under nominal operating conditions defined by a nominal supply frequency ($F_N$), a nominal supply voltage ($U_N$), a nominal supply intensity ($I_N$) and a nominal rotation speed ($N_N$), the machine comprising a rotor and a stator and a motorised fan equipped with a specific drive device, **characterised in that** the installation comprises means for supplying the motor with a given supply frequency, supply voltage and supply intensity, and means (36) for blocking the rotor of the motor in rotation relative to the stator, and **in that** it comprises:

a) means (32, 34) for measuring a first heating value $\Delta\theta_1$ of the machine when:

- the rotor is immobilized relative to the stator,
- the supply frequency is a first reduced frequency ($F_1$),

- the supply voltage is a first reduced voltage ($U_1$),
- the supply intensity is the nominal intensity ($I_1 = I_N$),
- the ventilation is in operation,

b) means (32, 34) for measuring a second heating value $\Delta\theta2$ of the machine when:

- the rotor is turning at a reduced rotation speed without load,
- the supply frequency is a second reduced frequency ($F_2$),
- the supply voltage is a second reduced voltage ($U_2$),
- the supply intensity is a second reduced intensity ($I_2$),
- the ventilation is in operation,

c) means (32, 34) for measuring a third heating value $\Delta\theta_3$ of the machine when:

- the rotor is turning at the nominal rotation speed without load,
- the supply frequency is the nominal frequency ($F_N$),
- the supply voltage is the nominal voltage ($U_N$),
- the supply intensity is equal to the intensity of the nominal magnetising current ($I_O$) of the machine,
- the ventilation is in operation,

d) means (324) for calculating, from the first, second and third heating values, the heating under nominal operating conditions by:

$$\Delta\theta a = \Delta\theta_1 - \Delta\theta_2 + \Delta\theta_3.$$

## FIG.1

Mesure de $\Delta\sigma_1$ — 41

Mesure de $\Delta\sigma_2$ — 42

Mesure de $\Delta\sigma_3$ — 43

$\Delta\sigma_a = \Delta\sigma_1 - \Delta\sigma_2 + \Delta\sigma_3$ — 44

## FIG.2

## FIG.3